# EUROPEAN PATENT APPLICATION

(11) **EP 2 317 550 A1**
(43) Date of publication of application: **04.05.2011**
(21) Application number: 09174458.1
(22) Date of filing: 29.10.2009
(51) Int. Cl.: H01L 23/38

(54) **Three-layered cold/hot controller**

(71) Applicant: Chang, Chia-Cheng, Taipei County 244 (TW)
(72) Inventor: Chang, Chia-Cheng, 244, Taipei County (TW); Chang, Rong-Ming, 244, Taipei County (TW)
(74) Representative: Becker, Eberhard

(57) **Abstract**

A three-layered cold/hot controller comprises a semiconductor plate, a first metal plate, and a second metal plate. The semiconductor plate has a top and a bottom contact surface and connected with a power source. When the semiconductor plate is electrified, the top contact surface of the semiconductor plate forms a contact surface for decreasing temperature while the bottom contact surface of the semiconductor plate forms a contact surface for elevating temperature. The first metal plate is combined to the top contact surface of the semiconductor plate for conducting the heat between the first metal plate and the top contact surface. The second metal plate is combined to the bottom contact surface of the semiconductor plate for conducting the heat between the second metal plate and the bottom contact surface.

## Description

### Technical Field

The present invention relates to a three-layered cold/hot controller including a semiconductor plate used for heat exchange when being electrified, where the semiconductor plate is combined with two metal plates for increasing or decreasing temperature rapidly. The three-layered cold/hot controller has simple structure and is compact, highly stable, and suitable for various electrical products.

### Background

With the rapid development of technology in modem times, various electrical products (such as personal computers, notebook computers, or other household appliances in daily lives) are essential to the lives of human beings. No matter being at work or at home, people spend more time to use electrical products.

Since the tendency is to make electrical products lighter, thinner, shorter, and smaller, the requirements for the extent of precision or size of various elements or processing apparatus become much stricter. In addition to being designed for protecting structure and providing appealing appearance for attracting consumers to purchase, the outer casings of various electrical products are also designed for heat dissipation.

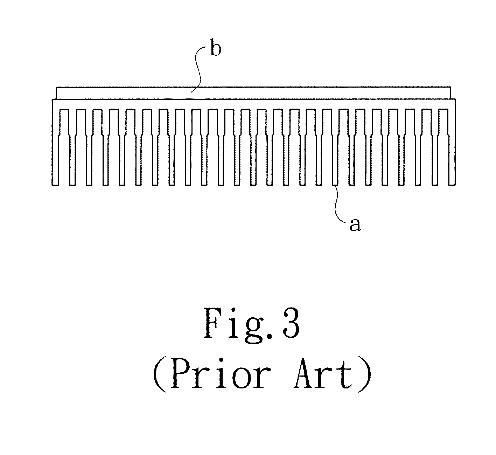

For electrical products, heat is typically dissipated into internal space thereof or dissipated into outer environment. As shown in Fig.3, heat dissipation blocks or heat sinks "a" made of metal with good thermal conductivity are most commonly used to contact the heat producing parts "b" of electrical products for heat dissipation. Alternately, it is also able to achieve heat dissipation effect by enlarging the area for heat exchange. Although using above methods can dissipate produced heat, the heat dissipation effect is limited. Moreover, because heat dissipation blocks or heat sinks have certain weight and volume, it is necessary to change the structural arrangement of electrical products in order to limit the whole volume and weight thereof within a certain range.

### Summary of the disclosure

An object of the present invention is to provide a three-layered cold/hot controller, which has simple structure and is compact and highly stable.

In order to achieve above object, the present invention provides a three-layered cold/hot controller comprising a semiconductor plate, a first metal plate, and a second metal plate. The semiconductor plate has a top and a bottom contact surface and is connected with a power source. When the semiconductor plate is electrified, the top contact surface of the semiconductor plate forms a contact surface for decreasing temperature while the bottom contact surface of the semiconductor plate forms a contact surface for elevating temperature. The first metal plate is combined to the top contact surface of the semiconductor plate for conducting the heat between the first metal plate and the top contact surface. The second metal plate is combined to the bottom contact surface of the semiconductor plate for conducting the heat between the second metal plate and the bottom contact surface.

In practice, the first and the second metal plates are copper alloy plates with high thermal conductivity coefficient.

In practice, the second metal plate is further connected with a heat dissipation device thereon and the heat dissipation device is at least a heat sink made of aluminum alloy.

The following detailed description, given by way of examples or embodiments, will best be understood in conjunction with the accompanying drawings.

### Brief Description of the Drawings

Fig. 1 shows the use of a three-layered cold/hot controller of the present invention.

Fig. 2 shows another use of the three-layered cold/hot controller of the present invention.

Fig. 3 shows the use of heat dissipation blocks for heat dissipation in the prior art.

### Detailed Description

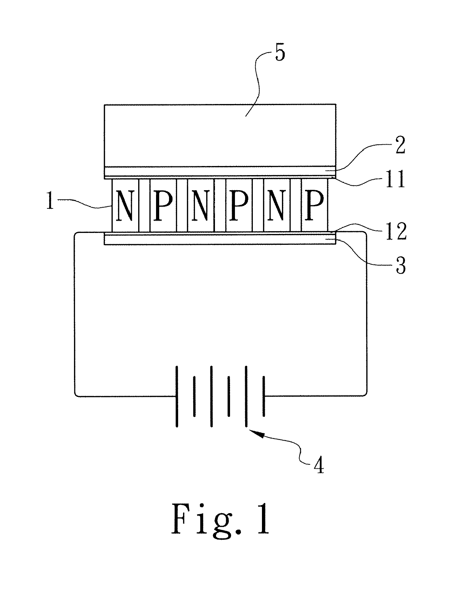

Please refer to Fig. 1 showing a preferred embodiment of a three-layered cold/hot controller of the present invention. In this embodiment, the three-layered cold/hot controller comprises a semiconductor plate 1, a first metal plate 2, and a second metal plate 3.

The semiconductor plate 1 has a top contact surface 11 and a bottom contact surface 12 and is connected with a power source 4. When the semiconductor plate 1 is electrified, the top contact surface 11 of the semiconductor plate 1 forms a contact surface for decreasing temperature while the bottom contact surface 12 of the semiconductor plate 1 forms a contact surface for elevating temperature. The first metal plate 2 is combined to the top contact surface 11 of the semiconductor plate 1 for conducting the heat between the first metal plate 2 and the top contact surface 11. The second metal plate 3 is combined to the bottom contact surface 12 of the semiconductor plate 1 for conducting the heat between the second metal plate 3 and the bottom contact surface 12. Besides, the first and the second metal plates 2, 3 are all copper alloy plates with high thermal conductivity coefficient.

Therefore, in practice, a semiconductor plate 1 is taken first. The top contact surface 11 of the semiconductor plate 1 forms a contact surface for decreasing temperature and is combined with the first metal plate 2. The bottom contact surface 12 of the semiconductor plate 1 forms a contact surface for elevating temperature and is combined with the second metal plate 3. Consequently, when the semiconductor plate 1 is electrified, heat will be conducted between the first, second metal plates 2, 3 and the top, bottom contact surfaces 11, 12. There would be a temperature decrease of about 65∼70°C on the first metal plate 2 and a temperature increase of about 80∼100 °C on the second metal plate 3. Accordingly, when the three-layered cold/hot controller of the present invention is used for heat dissipation of CPU5 in a computer, where the first metal plate 2 is in direct contact with the CPU5, the heat produced from the CPU5 can be dissipated via the first metal plate 2. In other words, the heat produced from the CPU5 can be neutralized on the first metal plate 2 to fulfill the heat dissipation purpose. On the contrary, if it is required to elevate the temperature of an electrical product, the temperature of the electrical product can be elevated rapidly by contacting the electrical product directly with the second metal plate 3.

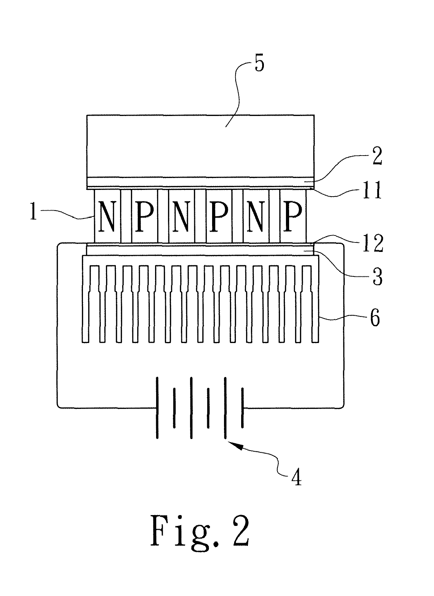

Moreover, as shown in Fig.2, the second metal plate 3 of the present invention can be further connected with a heat dissipation device 6 thereon. The heat dissipation device 6 is at least a heat sink made of aluminum alloy for dissipation the heat from the second metal plate 3.

Therefore, the present invention has following advantages:
1. By combining the semiconductor plate of advanced technology with two metal plates, a three-layered structure with temperature effect can be formed. When the three-layered structure is used in smaller and refined electrical products, it is able to lower or elevate the temperature of the electrical products, to further decrease the size thereof, and to reduce the amount of aluminum alloy used to form heat dissipation blocks. Accordingly, the manufacturing and processing cost can be decreased.
2. According to the present invention, after being electrified, the semiconductor plate works by means of temperature effect. Therefore, by means of altering current magnitude, temperature can be controlled, that is, decreased or increased effectively.

As disclosed in the above description and attached drawings, the present invention can provide a three-layered cold/hot controller. It is new and can be put into industrial use.

Although the embodiments of the present invention have been described in detail, many modifications and variations may be made by those skilled in the art from the teachings disclosed hereinabove. Therefore, it should be understood that any modification and variation equivalent to the spirit of the present invention be regarded to fall into the scope defined by the appended claims.

## Claims

1. A three-layered cold/hot controller, comprising:
a semiconductor plate, having a top and a bottom contact surface and connected with a power source, where when the semiconductor plate is electrified, the top contact surface of the semiconductor plate forms a contact surface for decreasing temperature while the bottom contact surface of the semiconductor plate forms a contact surface for elevating temperature;
a first metal plate, combined to the top contact surface of the semiconductor plate for conducting the heat between the first metal plate and the top contact surface; and
a second metal plate, combined to the bottom contact surface of the semiconductor plate for conducting the heat between the second metal plate and the bottom contact surface.

2. The three-layered cold/hot controller as claimed in claim 1, wherein the first and the second metal plates are copper alloy plates with high thermal conductivity coefficient.

3. The three-layered cold/hot controller as claimed in claim 1, wherein the second metal plate is further connected with a heat dissipation device thereon.

4. The three-layered cold/hot controller as claimed in claim 3, wherein the heat dissipation device is at least a heat sink made of aluminum alloy.
